# EUROPEAN PATENT APPLICATION

(11) **EP 1 918 979 A2**
(43) Date of publication of application: **07.05.2008**
(21) Application number: 07021209.7
(22) Date of filing: 30.10.2007
(51) Int. Cl.: H01L 21/00, H01L 21/311

(54) **Etching oxide with high selectivity to titanium nitride**

(30) Priority: 30.10.2006 US 554425
(71) Applicant: Applied Materials, Inc., Santa Clara, CA 95054 (US)
(72) Inventor: Hassan, Sajjad Amin, Fremont CA 94538 (US); Ying, Chentsau, Cupertino CA 95014 (US)
(74) Representative: Zimmermann, Gerd Heinrich

(57) **Abstract**

A substrate comprising an oxide layer covering a nitride layer, is etched in a process zone of a substrate processing chamber. A process gas comprising H₂ gas is introduced into the process zone, and the process gas is energized to etch through the oxide layer to at least partially expose the nitride layer. The energized process gas has a selectivity of etching the oxide layer to the nitride layer of at least about 25:1.

## Description

The present invention relates to the etching of oxide materials, and more specifically to the etching of oxide material above titanium nitride on a substrate.

In substrate fabrication processes, features of semiconductor, dielectric, and conducting materials are formed on a substrate, such as a semiconductor or glass substrate. In the fabrication process, layers of various materials are formed on the substrate by various deposition and other methods, such as for example, PVD, CVD, oxidization and nitridation. These layers are etched to form a pattern of features on the substrate using conventional lithography methods. In these methods, a layer of resist is applied on the substrate, the resist is exposed to a pattern of radiation, and then developed to form resist features. The portions of the underlying layer that are exposed and between the resist features are etched to form etched features. The etched features can include, for example, contact holes, fuses, pads, trenches and interconnect lines. The features are etched using a process gas that is energized by coupling heat or electrical energy to the process gas.

The features formed on the substrate are often composed of multiple materials, including, for example, antireflective layers, nitride layers, oxide layers and underlying barrier layers. In etching these different layers to form a feature, it is often desirable to etch through some of the layers and stop the etching process on other layers. For example, in a pad etching process, an oxide layer comprising silicon oxide is etched, and the etch process is stopped on a titanium nitride layer, which otherwise serves as a barrier layer. Etching through the titanium nitride layer is undesirable because it can result in etching of an underlying metal-containing layer, such as an aluminum layer, leading to sputtered aluminum deposits forming on the substrate and interior chamber and chamber component surfaces. These deposits contaminate the substrate and reduce the efficiency of use of the chamber by decreasing the number of processing cycles that can be performed in the chamber before such processing has to be stopped for cleaning of the chamber.

Stopping the etch process on an underlying layer becomes increasingly difficult as the underlying layer becomes ever thinner. Thinner layers are used to allow fabrication of ever smaller features and increased feature density. However, as the underlying layer becomes increasingly thin, it is desirable to have a high etching selectivity ratio for etching the overlying layer relative to the underlying layer to be able to stop the etch process on the underlayer without break-through of the underlayer. In the oxide over nitride example, it is desirable to have a high etching selectivity of etching the oxide material relative to etching of the underlying nitride material.

Thus, it is desirable to have an etching process with a high etching selectivity ratio of etching oxide material to titanium nitride. It is further desirable to stop the etching process on the underlayer without break-thorough. It is also desirable not to etch away underlying metal features or layers to avoid contaminating the substrate and chamber surfaces.

In view of the above, there is provided a method for etching a substrate as laid out in claim 1 and a substrate processing apparatus as laid out in claim 15. Further aspects, details, features and embodiments are evident from the dependent claims, the description and the accompanying drawings.

These features, aspects and advantages of the present invention will become better understood with regard to the following description, appended claims and accompanying drawings, which relate to embodiments of the invention. However, it is to be understood that each of the features can be used in the invention in general, not merely in the context of the particular drawings, and the invention includes any combination of these features, where:

FIG. 1 is a cross-sectional view of the substrate having layers and etched features;

FIG. 2 is a schematic cross-sectional view of an embodiment of a substrate processing apparatus comprising a process chamber; and

FIG. 3 is an illustrative block diagram of a hierarchical control structure of an embodiment of a computer program for operating the apparatus and chamber.

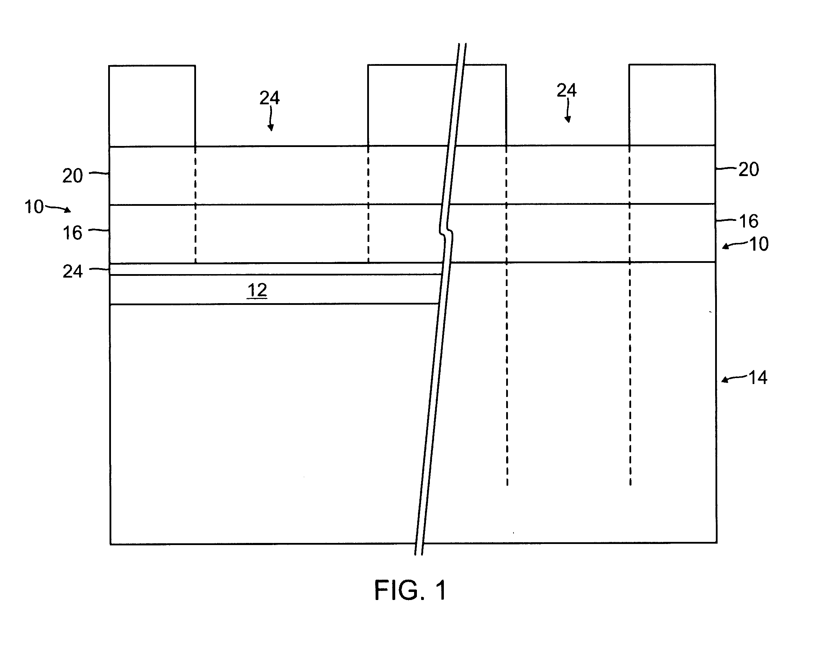

A substrate processing method selectively etches an oxide layer 10 formed above a titanium nitride layer 12 on a substrate 14. The substrate 14 may comprise a dielectric material, such as an oxide, for example, silicon dioxide, undoped silicate glass, phosphosilicate glass (PSG), borophosphosilicate glass (BPSG), or tetraethylorthosilicate (TEOS) deposited glass, formed over a titanium nitride layer 12. In one exemplary embodiment provided merely to illustrate the present process and apparatus 100, the dielectric material comprises a silicon dioxide layer 16 formed over a titanium nitride layer 12, as shown in FIG. 1. In one embodiment, the silicon dioxide layer 16 is formed over a silicon nitride layer 20; however, the silicon nitride layer 20 can also be formed over the silicon dioxide layer 16, as shown in FIG. 1. In one embodiment, the silicon dioxide layer 16 and the silicon nitride layer 20 each have a thickness of from about 1000 to about 2000 angstroms.

In a process of etching features 24 comprising the oxide material 10 on the substrate 14, the titanium nitride layer 12 can be used as an etch stop layer to stop etching and control the depth of etching. The nitride layer 12 has a thickness of from about 50 to about 2000 angstroms. In one embodiment, the titanium nitride layer 12 is formed over an aluminum layer 28 comprising interconnect lines and other features 24. While the etching process described below is illustrated by exemplary configurations of layers and materials of the features 24, it should be understood that the process can be applied to etching for various purposes, and the present invention should not be limited to these exemplary embodiments.

During processing, a substrate 14 to be etched is placed in a process zone, and a process gas is introduced into the process zone. The process gas comprises a composition of gases capable of being energized to etch through the oxide layer 10 on the substrate 14 to at least partially expose the underlying titanium nitride layer 12 on the substrate 14. A suitable process gas comprises an etchant gas and a hydrogen additive gas. The etchant gas can comprise a gas composition suitable for etching the oxide layer 10. The hydrogen additive gas significantly increases the desired selectivity of etching the oxide layer 10 to the titanium nitride layer 12. It is further believed that the hydrogen atoms from the added hydrogen gas react with other process gases to form a polymeric residue that deposit onto the surface of the titanium nitride layer 12 to slow down the etching rate of the titanium nitride layer 12. It is further believed that, although the etching of the oxide layer 10 and titanium nitride layer 12 each involve a physical and chemical process, the etching of the titanium nitride layer 12 is a more physical process than etching of the oxide layer 10. With the hydrogen gas present in the plasma, it is believed that the hydrogen gas consumes the fluorine present in the plasma, forming volatile hydrogen fluoride. Consequently, there is less fluoride available to attack the surface of the titanium nitride, which reduces the titanium nitride etch rate significantly.

The process gas composition is selected to provide a high etching selectivity ratio for etching the oxide layer 10 relative to the underlying titanium nitride layer 12. For example, a suitable process gas composition can be selected to provide a etching selectivity ratio for etching the oxide layer 10 to the underlying titanium nitride layer 12 of at least about 25:1, and even from about 26:1 to about 28:1.

The composition of the process gas may be selected to etch the oxide layer 10, as in one embodiment, a silicon dioxide layer 16, at a faster rate than the underlying titanium nitride layer 12, thereby at least partially removing the oxide layer 10 on the substrate 14 without overetching the titanium nitride layer 12. In one embodiment, a substrate 14 comprising a silicon dioxide layer 16 and silicon nitride layer 20, over a titanium nitride layer 12, is etched to provide an etching rate of the silicon dioxide layer 16 that is at least 6000 angstroms per minute.

In one embodiment, the etchant gas comprises a halogenated non-hydrogen-containing gas, which is a gas compound having a bonded halogen species and that is absent any bonded hydrogen. It is believed that this gas compound provides selective etching of the substrate 14. In one embodiment, the volumetric flow ratio of halogenated non-hydrogen-containing gas to hydrogen gas is from about 1:2 to about 12:1 and preferably, from about 2:1 to about 8:1. If the ratio of halogenated non-hydrogen-containing gas to hydrogen gas is less than about 1:2, the substrate is insufficiently etched, however, overetching takes place when the ratio is greater than about 12:1. A suitable halogenated non-hydrogen-containing gas comprises, for example, a carbon and fluorine containing gas compound, such as at least one of CF₄, C₂F₆ and C₄F₈. In one embodiment, the halogenated non-hydrogen-containing gas comprises CF₄.

In one embodiment, the etchant gas further comprises a halogenated hydrogen-containing gas which is a gaseous compound having at least one bonded hydrogen and a halogen comprising one or more of fluorine, chlorine, bromine and iodine. Halogenated hydrogen-containing gases such as, for example, CHF₃, CH₂F₂ and CH₃F, form a polymer on etch resistant material such as resist, for example, photoresist, overlying a substrate with features. The polymer is difficult to remove and therefore serves to protect the resist from etching and preserves the feature 24 walls and/or substrate 14 underlying the resist.

The process gas can also include a carrier gas. The carrier gas is an inert gas used to carry or transport the other constituent gases of the process gas. The carrier gas is inert to the extent that it does not take part in the process reaction. In one embodiment, the carrier gas is argon gas. Examples of other carrier gases include helium, nitrogen and neon gas.

The volumetric flow ratio of the components of the process gas is further selected to increase the desired selectivity of etching the oxide layer 10 to the titanium nitride layer 12. For example, the volumetric flow ratio of the etchant gas comprising the halogenated hydrogen-containing gas, the halogenated non-hydrogen containing gas and the hydrogen gas, to the non-reactive gas or carrier gas, such as argon, also affects the etching selectivity ratio of etching oxide to titanium nitride. In one embodiment, the volumetric flow ratio of etchant gas to carrier gas to hydrogen gas is about 10:10:1, respectively.

The process gas is energized to etch the oxide layer 10 to at least partially expose the titanium nitride layer 12, for example, by coupling RF or microwave energy to the process gas that is provided in a process zone of, for example, a substrate processing chamber, to etch the substrate 14. The energized process gas comprises energized etching gas species, such as reactive dissociated and radical species, that are capable of etching the oxide layer 10 on the substrate 14. The energized process gas etches features 24 on the substrate 14 by etching at least a portion of the oxide layer 10, such as a silicon dioxide layer 16, to expose the underlying titanium nitride layer 12, as shown in FIG. 1.

In one example, the process gas is energized to form a plasma for selectively etching the oxide and titanium nitride layers on the substrate 14 by applying RF source power to an antenna and an RF bias power to process electrodes. This application of power provides energized gas species that are directed towards the substrate 14 to etch the layers of the substrate 14. A suitable RF source power level may be at least about 500 Watts, and even at least about 200 Watts, for example, from about 500 to about 4500 Watts. A suitable RF bias power level is of from about 10 to about 2000 Watts.

The endpoint of the etching process may be determined by a spectroscopic method. The endpoint of the etching stage may occur, for example, when a layer of the substrate 14 has been sufficiently removed or etched through to reveal an underlying layer, or when a desired dimension, such as a desired height of a feature 24, has been obtained. Determining the endpoint of the etching stage allows for etching of the substrate 14 to be halted once completed, thereby reducing the occurrence of overetching or underetching of the substrate 14.

The endpoint may be determined by monitoring radiation emissions from plasma in the chamber that emits radiation, that changes in intensity and wavelength according to a change in the composition of the energized gas, such as for example, a change in composition arising from the etching through of an overlying layer to expose an underlying layer on the substrate 14. In one embodiment, the radiation emissions are monitored by detecting the intensities of one or more wavelengths of the radiation emission. A signal is generated in relation to the detected intensities and the signal is analyzed to determine a change in an intensity of one or more wavelengths of the radiation, such as an increase or decrease in the intensity that is indicative of the etching stage endpoint. In another embodiment, the etching endpoint can also be determined by monitoring radiation reflected from the substrate 14 during the etching process.

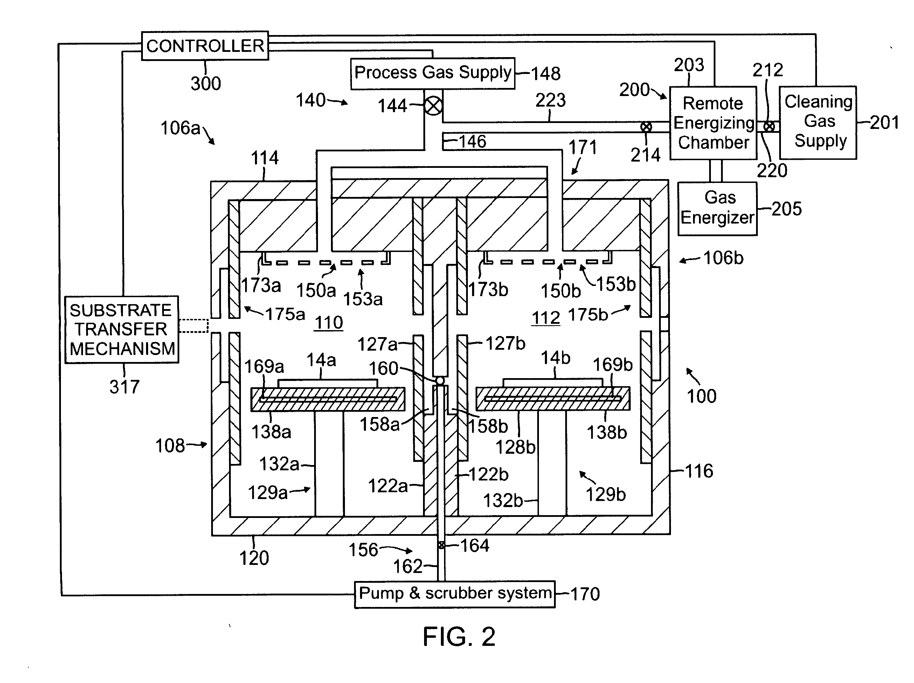

The particular embodiment of a substrate processing apparatus 100, as shown in FIG. 2, is suitable for processing substrates 14, such as semiconductor substrates, according to the processes described herein, and may be adapted by those of ordinary skill to process other substrates 14 such as flat panel displays, polymer panels or other electrical circuit receiving structures. Thus, the apparatus 100 should not be used to limit the scope of the invention, nor its equivalents, to the exemplary embodiments provided herein.

The substrate processing apparatus 100 comprises exemplary tandem chambers, as in a Producer™ etch system available from Applied Materials, Santa Clara, California. The apparatus 100 comprises processing chambers 106a,b which allow for the processing of multiple substrates 14a,b in a single processing environment, for example, as schematically illustrated in FIG. 2. The chambers 106a,b are defined by a chamber wall 108 and include two process zones 110, 112 in which individual substrates 14a,b are concurrently processed. The chamber wall 108 comprises a lid 114, sidewalls 116, bottom wall 120 and interior walls 122a,b, which cooperate to define the two process zones 110, 112. Chamber liners 127a,b, which may be made of a ceramic material such as aluminum oxide or aluminum nitride, are disposed in each process zone 110, 112to protect the chamber wall 108.

FIG. 2 further shows a substrate support 129a,b comprising a pedestal in each process zone 110, 112. The pedestal further comprises a stem 132a,b which is connected to the underside of the pedestal 138a,b. The stem extends through the bottom wall 120 of the chamber 106a,b where it is connected to a drive system (not shown). The stem 132a,b mechanically positions the pedestal 138a,b within the process zone 110, 112. The stem 132a,b moves upwardly and downwardly in the chamber 106a,b to move the pedestal 138a,b to position a substrate 14a,b thereon for processing or removing the substrate 14a,b therefrom. Each pedestal 138a,b may include a heater (not shown) to heat a substrate 14a,b positioned thereon, to a desired process temperature. The substrate support 129a,b further comprises a process electrode 169a,b embedded in the support 129a,b.

A gas is introduced into the chamber 106a,b by a gas delivery system 140. In one embodiment, the gas delivery system has gas flow valves 144 on a gas feed line 146 that transports gases from a gas supply 148 to the gas distributors 150a,b in each process zone 110, 112. The gas distributors 150a,b each comprise a gas distribution plate 173a,b, which also serves as a process electrode, having gas outlets 153a,b through which gas may exit the gas distributors 150a,b into the process zones 110, 112. The process gas introduced into the chamber 106a,b is exhausted by an exhaust system 156 that includes pumping channels 158a,b, an exhaust conduit 160, an exhaust line 162, a throttle valve 164, and a pump and scrubber system 170, which may include roughing and turbo-molecular pumps. The pumping channels 158a,b in each process zone 110, 112 circumferentially surround the process zones 110, 112 and receive the gas provided in each process zone 110, 112 for exhausting the gas. The pumping channels 158a,b of each process zone 110, 112 are connected to the shared pump and scrubber system 170 via the exhaust conduit 160 and the shared exhaust line 162. The exhaust conduit 160 is a port or channel that transports gas from the pumping channels 158a,b to the exhaust line 162 located at the back of the apparatus 100. The exhaust line 162 extends along the back of the apparatus 100 and connects the exhaust conduit 160 to the pump and scrubber system 170. The throttle valve 164 in the exhaust line 162 may be used to control the pressure of the gas in the chamber 106a,b.

The gas provided into the processing regions 110, 112 may be energized by coupling electromagnetic energy into the processing regions 110, 112 of the chambers 106a,b. In one embodiment, the gas may be energized by providing an RF source power to an antenna 171 and an RF bias potential to the gas distribution plate 173a,b and electrodes 169a,b to facilitate generation of an energized gas between the gas distribution plate 173a,b of the gas distributor and the pedestal 138a,b. The power level of the RF bias current may be from about 500 to about 4500 Watts and the power level of the RF source current may be from about 10 to about 2000 Watts.

The gas delivery system 140 may also comprise a remote plasma source 200 to deliver an energized cleaning gas to the chamber 106a,b. The energized cleaning gas may be provided into the chamber 106a,b to remove deposited material from the interior surfaces 175a,b of the chamber 106a,b after one or more substrate processing iterations. The remote plasma source 200 may comprise a cleaning gas supply 201, a remote chamber 203, a gas energizer 205 and gas transfer conduits 212, 214. Control valves 212, 214 control the flow of cleaning gas through the conduits 220, 223. The cleaning gas from the cleaning gas supply 201 may be transferred by the conduit 212 to the remote chamber 203 where the cleaning gas may be energized by a gas energizer 205. The gas energizer 205 couples electromagnetic energy to the cleaning gas to form reactive species. In one embodiment, the gas energizer 205 couples microwave energy to the cleaning gas. The gas energizer 205 may comprise a 200 KHz to 2 GHz microwave generator, which may supply from about 500 Watts to about 8 Kilowatts to the remote chamber 203. Once activated, the cleaning gas is transferred by the gas transfer conduit 223 from the remote chamber 203 to the gas feed line 146. The gas feed line 146 delivers the energized cleaning gas to the gas distributors 150a,b in each process zone 110, 112.

The apparatus 100 may further comprise a process monitor (not shown) adapted to monitor a process being conducted in the chamber 106a,b. The process monitor may be an interferometer or a plasma emission analyzer. The plasma emission analyzer typically receives a radiation emission emitted from a plasma in the process zone and analyzes the intensity of particular wavelengths of the emission spectra to determine an endpoint of a process. The interferometer detects radiation, such as light, that is interferometrically reflected from the surface layers on the substrate 14 to determine an end of processing of a layer. The reflected radiation may originate from a radiation source or from the plasma in the chamber 106a,b. In one embodiment, the process monitor comprises a radiation source to direct a radiation beam toward the substrate 14. The incident radiation beam is reflected from the substrate 14 to form a reflected beam and a radiation detector receives the reflected beam to determine a property of the process or the substrate 14. The radiation may be light, such as infra-red, visible or ultraviolet light.

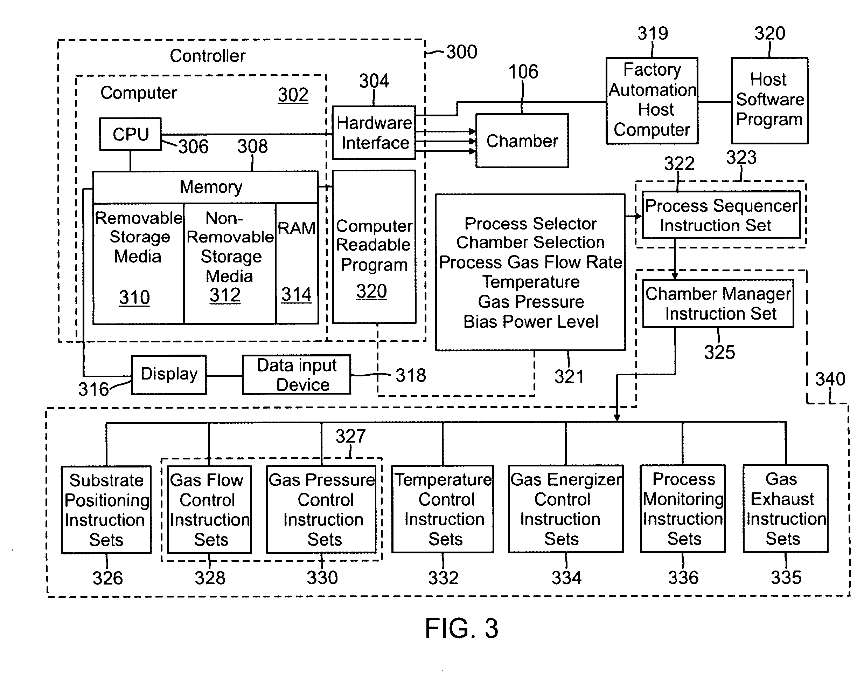

The chamber 106a,b may be operated by a controller 300 comprising a computer 302 that sends instructions via a hardware interface 304 to operate the chamber components, for example, the substrate support 129a,b to raise and lower the substrate support 129a,b, the gas flow control valves 144a,b, the gas energizer 205 and the exhaust 143. The process conditions and parameters measured by the different detectors in the chamber 106a,b are sent as feedback signals by control devices such as the gas flow control valves 144, pressure monitor (not shown), throttle valve 164, and other such devices, are transmitted as electrical signals to the controller 300. Although, the controller 300 is illustrated by way of an exemplary single controller device to simplify the description of present invention as shown in FIG. 3, it should be understood that the controller 300 may be a plurality of controller devices that may be connected to one another or a plurality of controller devices that may be connected to different components of the chamber 106a,b. Thus, the present invention should not be limited to the illustrative and exemplary embodiments described herein.

The controller 300 comprises electronic hardware including electrical circuitry comprising integrated circuits that is suitable for operating the chamber 106a,b and its peripheral components. Generally, the controller 300 is adapted to accept data input, run algorithms, produce useful output signals, detect data signals from the detectors and other chamber components, and to monitor or control the process conditions in the chamber 106a,b. For example, the controller 300 may comprise a computer 302 comprising (i) a central processing unit (CPU) 306, such as for example, a conventional microprocessor from INTEL corporation, that is coupled to a memory 308 that includes a removable storage medium 310, such as for example a CD or floppy drive, a non-removable storage medium 312, such as for example a hard drive or ROM, and RAM 314; (ii) application specific integrated circuits (ASICs) that are designed and preprogrammed for particular tasks, such as retrieval of data and other information from the chamber 106a,b, or operation of particular chamber components; and (iii) interface boards that are used in specific signal processing tasks, comprising, for example, analog and digital input and output boards, communication interface boards, and motor controller boards. The controller interface boards, may, for example, process a signal from a process monitor and provide a data signal to the CPU 306. The computer also has support circuitry that includes, for example, co-processors, clock circuits, cache, power supplies and other well known components that are in communication with the CPU 306. The RAM 314 can be used to store the software implementation of the present invention during process implementation. The instruction sets of code of the present invention are typically stored in storage mediums and are recalled for temporary storage in RAM 314 when being executed by the CPU 306. The user interface between an operator and the controller 300 can be, for example, via a display 316 and a data input device 318, such as a keyboard or light pen. To select a particular screen or function, the operator enters the selection using the data input device 318 and can review the selection on the display.

The data signals received and evaluated by the controller 300 may be sent to a factory automation host computer 319. The factory automation host computer 319 may comprise a host software program 320 that evaluates data from several systems, platforms or chambers 106a,b, and for batches of substrates 14 or over an extended period of time, to identify statistical process control parameters of (i) the processes conducted on the substrates 14, (ii) a property that may vary in a statistical relationship across a single substrate 14, or (iii) a property that may vary in a statistical relationship across a batch of substrates 14. The host software program 320 may also use the data for ongoing in-situ process evaluations or for the control of other process parameters. A suitable host software program 320 comprises a WORKSTREAM™ software program available from aforementioned Applied Materials. The factory automation host computer 319 may be further adapted to provide instruction signals to (i) remove particular substrates 14 from the etching sequence, for example, if a substrate property is inadequate or does not fall within a statistically determined range of values, or if a process parameter deviates from an acceptable range; (ii) end processing in a particular chamber 106a,b, or (iii) adjust process conditions upon a determination of an unsuitable property of the substrate 304 or process parameter. The factory automation host computer 319 may also provide the instruction signal at the beginning or end of etching of the substrate 14 in response to evaluation of the data by the host software program 320.

In one embodiment, the controller 300 comprises a computer program 320 that is readable by the computer 302 and may be stored in the memory 308, for example on the non-removable storage medium 312 or on the removable storage medium 310. The computer program 320 generally comprises process control software comprising program code comprising instructions to operate the chamber 106a,b and its components, process monitoring software to monitor the processes being performed in the chamber 106a,b, safety systems software, and other control software. The computer program 320 may be written in any conventional programming language, such as for example, assembly language, C++, Pascal, or Fortran. Suitable program code is entered into a single file, or multiple files, using a conventional text editor and stored or embodied in computer-usable medium of the memory. If the entered code text is in a high level language, the code is compiled, and the resultant compiler code is then linked with an object code of pre-compiled library routines. To execute the linked, compiled object code, the user invokes the object code, causing the CPU 306 to read and execute the code to perform the tasks identified in the program.

An illustrative block diagram of a hierarchical control structure of a specific embodiment of a computer program 320 according to the present invention is shown in FIG. 3. Using the data input device 318, for example, a user enters a process set into the computer program 320 in response to menus or screens on the display 316 that are generated by a process selector 321. The computer program 320 includes instruction sets to control the substrate transfer mechanism 317, substrate support 129a,b, gas distributor 140a,b, gas exhaust 143, gas energizer 205, and other components involved in a particular process, as well as instructions sets to monitor the chamber process. The process sets are predetermined groups of process parameters necessary to carry out specified processes. The process parameters are process conditions, including, without limitations, substrate position, gas composition, gas flow rates, temperature, pressure, and gas energizer settings such as RF or microwave power levels.

A process sequencer 323 comprises instruction sets 322 to accept a set of process parameters from the computer program 320 or the process selector 321 and to control its operation. The process sequencer 323 initiates execution of the process set by passing the particular process parameters to a chamber manager 324 that controls multiple tasks in the chamber 106a,b. The chamber manager 324 may include instruction sets, such as for example, chamber manager instruction sets 325, substrate positioning instruction sets 326, gas distributor instruction sets 327 comprising gas flow control instruction sets 328 and gas pressure control instruction sets 330, temperature control instruction sets 332, gas energizer control instruction sets 334, gas exhaust control instruction sets 335 and process monitoring instruction sets 336.

The substrate positioning instruction sets 326 comprise, for example, substrate transfer mechanism instruction sets comprising code for controlling the substrate transfer mechanism 317 that is used to load and unload a substrate 14 from the support 129a,b. In one embodiment, the instruction sets 326 comprise program code to operate the substrate transfer mechanism 317 to provide a substrate 14 comprising a silicon dioxide layer 16 above a titanium nitride layer 12, into the chamber 106a,b. The substrate positioning instruction sets 326 further comprise substrate support instruction sets comprising code to lift and lower a support 129a,b to a desired height in the chamber 106a,b and to lift and lower a substrate 14 from the receiving surface of the substrate support 129a,b to a raised position a distance of height above the receiving surface of the substrate support 129a,b 8 as well as lower the substrate 14 back down to contact or rest upon the substrate receiving surface of the support 129a,b.

The gas distributor instructions sets 327 comprise gas pressure control instruction sets 330 comprising program code for controlling the pressure in the chamber 106a,b by regulating the position of the throttle valve 164. For example, the position of the throttle valve 164 is regulated by the extent to which the throttle valve 164 is open or closed. The gas distributor instructions sets 327 further comprise gas flow control instruction sets 328 comprising code for controlling the flow rates of different constituents of the process gas. For example, the gas flow control instruction sets 328 may regulate the opening size of the gas flow control valves to obtain the desired gas flow rates from the gas outlets into the chamber 106a,b. In one embodiment, the gas distributor instruction sets 327 comprise code to introduce a process gas comprising an etchant gas, a carrier gas and H₂ gas into the chamber 106a,b, where the process gas has a selectivity of etching the silicon dioxide layer 16 to the titanium nitride layer 12 of at least 25:1 and even from about 26:1 to about 28:1. In one embodiment, the gas distributor instruction sets 327 comprise program code to operate the gas distributor 140a,b to introduce a process gas comprising an etchant gas comprising CHF₃ and CF₄, and a carrier gas comprising Ar. In one embodiment, the gas distributor instruction sets comprise program code to operate the gas distributor 140a,b to introduce a process gas comprising an etchant gas, carrier gas and H₂ gas into the chamber 106a,b wherein the volumetric flow ratio of etchant gas to carrier gas to H₂ gas is about 10:10:1.

In one embodiment, the chamber manager 324 comprises program code comprising gas pressure instruction sets 330 to control the pressure in the chamber 106a,b by regulating the position of the throttle valve 164. The gas pressure instruction sets 330 comprise code to operate the gas distributor 140a,b and gas exhaust 143 to maintain the pressure in the chamber 106a,b from about 50 to about 600mT.

The temperature control instruction sets 332 may comprise code for controlling the temperature of the substrate support 129a,b during etching, for example, by the gas filled lamps or the resistive heater in substrate support 129a,b. The temperature control instruction sets 332 may further comprise code for controlling the temperature of the walls of the chamber 106a,b, such as the temperature of the sidewalls 205a,b or ceiling 215.

The gas energizer control instruction sets 334 comprise code for setting, for example, the bias RF power level applied to the process electrodes 169a,b and 173a,b, and the source RF power applied to the antenna 171. In one embodiment, the gas energizer control instruction sets 334 comprise code for setting a bias RF power level applied to process electrodes 169a,b and 173a,b, and a source RF power level to the antenna 171, thereby energizing the process gas to etch the silicon dioxide layer 16 at a faster rate than the titanium nitride layer 12. In one embodiment, the gas energizer control instruction sets 334 comprise code for setting a bias RF power level applied to process electrodes 169a,b and 173a,b, and a source RF power level to the antenna 171, thereby energizing the process gas to etch the silicon dioxide layer 16 at a rate greater than about 6000 angstroms per minute. In one embodiment, the gas energizer control instruction sets 334 comprise code for setting a bias RF power level of from about 500 to about 4500 Watts to the electrodes 169a,b and a source RF power level of from about 1000 to about 2000 Watts to the antenna 171.

The process monitoring instruction sets 336 may comprise program code to monitor a process in the chamber 106a,b. For example, the process monitoring instruction sets may comprise program code to analyze a signal generated in relation to the detected intensities of wavelengths of radiation reflected from the substrate 14 or energized gas radiation emissions. The process monitoring instruction sets 336 comprise program code to analyze a signal trace of the intensities of the wavelengths by counting the number of minima and maxima detected in the signal to determine the interference fringes in the measured reflected light beam and from that, the thickness of a layer on the substrate 14. The process monitoring instruction sets 336 may also comprise program code to analyze the signal and compare portions of the signal waveform to a stored characteristic waveform, or other representative pattern, to detect a characteristic feature indicative of the etching endpoint.

While described as separate instruction sets for performing a set of tasks, it should be understood that each of these instruction sets can be integrated with one another, or the tasks of one set of program code integrated with the tasks of another to perform the desired set of tasks. Thus, the controller 300 and the computer program 320 described herein should not be limited to the specific embodiment of the functional routines described herein; and any other set of routines or merged program code that perform equivalent sets of functions are also in the scope of the present invention. Also, while the controller 300 is illustrated with respect to one embodiment of the chamber 106a,b, it may be compatible for use with other chambers.

The following example illustrates an exemplary method of etching a substrate 14 comprising an oxide layer 10 disposed above a titanium nitride layer 12, according to the present invention. While the example demonstrates one embodiment, the present invention may be used in other processes and for other uses as would be apparent to those of ordinary skill in the art. Therefore, the invention should not be limited to the example provided herein.

In this example, substrates 10 comprising a silicon dioxide layer 16 and a silicon nitride layer 20, disposed above a titanium nitride layer 12 overlying an aluminum layer 28. The substrate 14 were etched in a chamber 106a,b as described above. Table 1 illustrates the process parameters used in etching the substrates 10. Specifically, Table 1 illustrates the different etching selectivity of silicon dioxide to titanium nitride achieved, with and without the use of hydrogen gas as an additive gas in the process gas.

**Table 1**

| CHF₃ (sccm) | CF₄ (sccm) | Ar (sccm) | H₂ (sccm) | Pressure (mTorr) | Source Power (Watts) | Bias Power (Watts) | Electrode Gap (inches) | SiO₂ Etch Rate (A/min) | TiN Etch rate (A/min) | Selectivity (SiO₂:TiN) |
|---|---|---|---|---|---|---|---|---|---|---|
| 100 | 400 | 500 | 200 | 450 | 1500 | 3500 | 1.5 | 1557 | 190 | 32.9 |
| 100 | 400 | 500 | 50 | 450 | 1500 | 3500 | 1.5 | 7466 | 280 | 26.7 |
| 100 | 400 | 500 | 50 | 450 | 1500 | 3500 | 1.5 | 7090 | 260 | 27.3 |
| 100 | 400 | 500 | 0 | 450 | 1500 | 3500 | 1.5 | 7050 | 420 | 16.8 |

In one embodiment, a substrate 14 was etched in the chamber 106a,b by introducing a process gas comprising (i) a halogenated hydrogen-containing gas comprising CHF₄; (ii) a halogenated non-hydrogen-containing gas comprising CF₄; (iii) a carrier gas comprising Ar and (iv) an additive gas comprising H₂, into the process zone 202,203. The CHF₃ was introduced at a gas flow rate of about 100 sccm, the CF₄ was introduced at a gas flow rate of about 144 sccm, the Ar was introduced at a gas flow rate of about 500 sccm, and the H₂ was introduced at a gas flow rate equivalent to 500 sccm into the chamber 106a,b to provide a volumetric flow ratio of CHF₃ to CF₄ to Arto H₂ gas of about 2:8:10:1. The pressure of the chamber 106a,b was maintained at about 450 mTorr. The process gas was energized to etch the substrate 14 by applying a bias power level to the process electrodes of about 3500 Watts and a source power level to the antenna of about 1500 Watts. The gap between the process electrodes was maintained in this embodiment at about 1.5 inches, however the gap may range from about 1 to about 4 inches. The substrate 14 was exposed to the process gas from the outer zone of the showerhead. The inner zone of the shower head is defined as the area within an 8 inch radius, as measured from the center of the showerhead. The outer zone of the shower head consists of the remaining area, which in this case was the area as defined by the remaining 32 inches of the radius of the showerhead having had a 40 inch radius. Under these process parameters, the layers of the substrate 14 were etched at suitable rates. The silicon dioxide layer 16 was etched at a rate greater than about 6000 angstroms per minute and in the range of from about 6000 to about 8500 angstroms per minute. The titanium nitride layer 12 was etched at a rate less than about 300 angstroms per minute and in the range of from about 250 to about 300 angstroms per minute. The ratio of the etch rate of silicon dioxide to titanium nitride, resulted in an etch selectivity of at least about 25:1 and in the range of about 26:1 to about 28:1. The endpoint of the etching stage was determined by monitoring polarized radiation reflected from the surface of the substrate 14.

In another embodiment, the substrate 14 was etched in the chamber 106a,b under identical process parameters as the embodiment described above, except that the process gas did not contain the additive gas comprising hydrogen gas. The data presented in the bottom row of Table 1 reflects the selectivity of silicon dioxide to titanium nitride achieved without the addition of hydrogen gas. As the data illustrates, though the etch rate of silicon dioxide remained relatively the same, the etch rate of the titanium nitride was about 1.5 times faster than it was when the process gas comprised the hydrogen gas additive. This resulted in a lower etch selectivity ratio of silicon dioxide to titanium nitride of about 17:1.

Although the present invention has been described in considerable detail with regard to certain preferred embodiments thereof, other embodiments are possible. For example, the present invention could be used with etching gases other than those specifically mentioned, and could be used to etch other semiconductor and dielectric materials besides those mentioned. The process chamber 106a,b may also comprise other equivalent configurations as would be apparent to one of ordinary skill in the art. Further, it should be understood that the apparatus 100 as described above is not limited to the illustrative chamber, and other types of substrate processing chambers may be used. Thus, the appended claims should not be limited to the description of the preferred embodiments contained herein.

The invention is also directed to an apparatus for carrying out the disclosed methods and including apparatus parts for performing each described method steps. These method steps may be performed by way of hardware components, a computer programmed by appropriate software, by any combination of the two or in any other manner. Furthermore, the invention is also directed to methods by which the described apparatus operates. It includes method steps for carrying out every function of the apparatus.

## Claims

1. A method for etching a substrate, the method comprising:
(a) providing a substrate in a process zone, the substrate comprising an oxide layer above a titanium nitride layer;
(b) introducing a process gas comprising H₂ into the process zone; and
(c) energizing the process gas to etch through the oxide layer to at least partially expose the titanium nitride layer, the energized process gas having an etching selectivity ratio of etching the oxide layer to etching the titanium nitride layer of at least 25:1.

2. A method according to claim 1 wherein (a) comprises providing a substrate comprising at least one of:
(1) an oxide layer comprising silicon dioxide;
(2) a silicon nitride layer above the titanium nitride layer; and
(3) aluminum features under the titanium nitride layer.

3. A method according to claim 2 wherein (c) comprises energizing the process gas to obtain an selectivity ratio of etching the silicon dioxide layer to etching the titanium nitride layer that is from about 26:1 to about 28:1, and to obtain an etching rate that is greater than about 6000 angstroms per minute.

4. A method according to claim 1 wherein in (b) the process gas comprises a halogenated non-hydrogen-containing gas and a carrier gas.

5. A method according to claim 4 wherein the volumetric flow ratio of the halogenated non-hydrogen-containing gas to hydrogen gas is from about 1:2 to about 12:1.

6. A method according to claim 5 wherein the volumetric flow ratio of halogenated non-hydrogen-containing gas to hydrogen gas is from about 2:1 to about 8:1.

7. A method according to claim 4 wherein (i) the halogenated non-hydrogen-containing gas comprises at least one of CF₄, C₂F₆ and C₄F₈, and (ii) the carrier gas comprises at least one of Ar, He, N₂ and Ne.

8. A method according to claim 7 further comprising a halogenated hydrogen-containing gas comprising at least one of CHF₃, CHF₃, CH₂F₂ and CH₃F.

9. A method according to claim 1 wherein step (c) comprises energizing the process gas by coupling a source RF power of from about 500 to about 4500 Watts and a bias RF power of from about 10 to about 2000 Watts to the process gas.

10. A method according to claim 1 wherein the substrate processing chamber comprises an antenna and process electrodes, and wherein (c) comprises applying a bias RF power level to the process electrodes and a source RF power level to the antenna to energize the process gas.

11. A method according to claim 10 wherein in (b) the process gas further comprises an etchant gas comprising CF₄ and CHF₃, and a carrier gas comprising Ar.

12. A method according to claim 11 wherein the volumetric flow ratio of etchant gas to carrier gas to H₂ gas is about 10:10:1.

13. A method according to claim 12 wherein the bias RF power level is from about 500 to about 4500 Watts and the source RF power level is from about 10 to about 2000 Watts.

14. A method according to claim 10 wherein (c) further comprises applying a bias RF power level to the process electrodes having a gap therebetween of from about 1 to about 4 inches.

15. A substrate processing apparatus comprising:
(a) a process chamber comprising:
(i) a substrate support comprising a receiving surface for a substrate;
(ii) a gas distributor to distribute a process gas in the chamber;
(iii) a gas energizer to energize the process gas, the gas energizer comprising an antenna and process electrodes; and
(iv) a gas exhaust to exhaust the process gas;
(b) a substrate transfer mechanism communicable to the process chamber, the substrate transfer mechanism configured to transfer a substrate to the chamber; and
(c) a controller operatively coupled to the process chamber, the substrate transfer mechanism, the gas distributor, the gas energizer and the gas exhaust, the controller comprising a program code that includes instructions to operate:
(i) the substrate transfer mechanism;
(ii) the gas distributor; and
(iii) the gas energizer to apply a bias RF power level to the process electrodes and a source RF power level to the antenna, wherein the process gas is energized to etch a silicon dioxide layer relative to a titanium nitride layer with an etching selectivity ratio of at least 25:1.

16. An apparatus according to claim 15 wherein the program code comprises at least one of:
(a) instructions to operate the gas distributor and gas energizer to provide in the chamber an energized process gas having an etching ratio of etching the silicon dioxide layer to the titanium nitride layer of from about 26:1 to about 28:1;
(b) instructions to operate the gas energizer to apply a bias RF power level to the process electrodes and a source RF power level to the antenna, thereby energizing the process gas to etch the silicon dioxide layer at a rate greater than about 6000 angstroms per minute;
(c) instructions to operate the gas distributor to introduce a process gas comprising an etchant gas comprising CHF₃ and CF₄, and a carrier gas comprising Ar;
(d) instructions to operate the gas distributor to introduce a process gas comprising an etchant gas, carrier gas and H₂ gas into the chamber wherein the volumetric flow ratio of etchant gas to carrier gas to H₂ gas is about 10:10:1;
(e) instructions to operate the gas energizer to apply a bias RF power level of from about 500 to about 4500 Watts to the process electrodes and a source RF power level of from about 10 to about 2000 Watts to the antenna; or
(f) instructions to operate the gas distributor and gas exhaust to maintain the pressure in the chamber at from about 50 to about 600mT.
